# EUROPEAN PATENT APPLICATION

(11) **EP 4 651 201 A1**
(43) Date of publication of application: **19.11.2025**
(21) Application number: 24176205.3
(22) Date of filing: 16.05.2024
(51) Int. Cl.: H01L 23/053, H01L 23/22, H01L 23/24, H01L 23/29, H01L 23/31, H01L 23/498, H01L 23/00, H01L 25/07, H01L 23/538

(54) **POWER SEMICONDUCTOR MODULE ARRANGEMENT AND METHODS FOR PRODUCING THE SAME**

(71) Applicant: Infineon Technologies AG, 85579 Neubiberg (DE)
(72) Inventor: HERZER, Anita, 67655 Kaiserslautern (DE); WIESEMANN, Markus, 33605 Bielefeld (DE)
(74) Representative: Westphal, Mussgnug & Partner, Patentanwälte mbB

(57) **Abstract**

A power semiconductor module arrangement comprises a housing comprising sidewalls, a substrate with at least one semiconductor body arranged thereon, wherein the substrate is arranged in or forms a base surface of the housing, an encapsulant partly filling the housing, and completely covering the substrate and the at least one semiconductor body arranged thereon, wherein the encapsulant comprises one or more layers, and a structure, wherein the structure is embedded in one layer of the one or more layers of the encapsulant, and wherein the structure comprises or consists of a material that it different from the material of the layer it is embedded in.

## Description

### TECHNICAL FIELD

The instant disclosure relates to a power semiconductor module arrangement and to methods for producing such a power semiconductor module arrangement.

### BACKGROUND

Power semiconductor module arrangements often include at least one substrate. A semiconductor arrangement including a plurality of controllable semiconductor elements (e.g., two or more IGBTs) is arranged on each of the at least one substrate. Each substrate usually comprises a substrate layer (e.g., a ceramic layer), a first metallization layer deposited on a first side of the substrate layer and a second metallization layer deposited on a second side of the substrate layer. The controllable semiconductor elements are mounted, for example, on the first metallization layer. Most power semiconductor module arrangements further include an encapsulant at least partly filling the interior of the housing, thereby covering any components and electrical connections that are arranged on the at least one substrate. The encapsulant is generally configured to protect the components and electrical connections of the power semiconductor module from certain environmental conditions and mechanical damage. An encapsulant may comprise a single layer or more than one layer. Each of the one or more layers of the encapsulant has certain properties. Most materials that are suitable for forming a layer of an encapsulant, however, provide certain specific advantages but are not able to combine several different advantages. That is, for example, a layer of an encapsulant may provide a high mechanical stability, but at the same time may only provide a comparably poor thermal conductivity, or vice versa. This similarly applies to other properties a layer may provide.

There is a need for an improved power semiconductor module arrangement and for methods which allow to produce such a power semiconductor module arrangement at low costs.

### SUMMARY

A power semiconductor module arrangement includes a housing including sidewalls, a substrate with at least one semiconductor body arranged thereon, wherein the substrate is arranged in or forms a base surface of the housing, an encapsulant partly filling the housing, and completely covering the substrate and the at least one semiconductor body arranged thereon, wherein the encapsulant includes one or more layers, and a structure, wherein the structure is embedded in one layer of the one or more layers of the encapsulant, and wherein the structure includes or consists of a material that it different from the material of the layer it is embedded in.

A method includes forming an encapsulant in a housing of a power semiconductor module arrangement, the housing including sidewalls, and the power semiconductor module arrangement including a substrate with at least one semiconductor body arranged thereon, wherein the substrate is arranged in or forms a base surface of the housing, wherein the encapsulant includes one or more layers, and a structure is embedded in one layer of the one or more layers of the encapsulant, wherein the structure includes or consists of a material that it different from the material of the layer it is embedded in.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1 is a cross-sectional view of a power semiconductor module arrangement.
Figure 2 is a cross-sectional view of a power semiconductor module arrangement according to embodiments of the disclosure.
Figure 3 is a cross-sectional view of a power semiconductor module arrangement according to further embodiments of the disclosure.
Figure 4, including Figures 4A to 4E, schematically illustrates top views of power semiconductor module arrangements according to embodiments of the disclosure.
Figure 5, including Figures 5A and 5B, schematically illustrates a method for forming a power semiconductor module arrangement according to embodiments of the disclosure.
Figure 6 schematically illustrates another method for forming a power semiconductor module arrangement according to embodiments of the disclosure.
Figure 7, including Figures 7A and 7B, schematically illustrates an even further method for forming a power semiconductor module arrangement according to embodiments of the disclosure.
Figure 8, including Figures 8A and 8B, schematically illustrates a power semiconductor module arrangement according to embodiments of the disclosure when no heat is generated and when heat is generated in the power semiconductor module arrangement.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description as well as in the claims, designations of certain elements as "first element", "second element", "third element" etc. are not to be understood as enumerative. Instead, such designations serve solely to address different "elements". That is, e.g., the existence of a "third element" does not necessarily require the existence of a "first element" and a "second element". An electrical line or electrical connection as described herein may be a single electrically conductive element, or include at least two individual electrically conductive elements connected in series and/or parallel. Electrical lines and electrical connections may include metal and/or semiconductor material, and may be permanently electrically conductive (i.e., non-switchable). A semiconductor body as described herein may be made from (doped) semiconductor material and may be a semiconductor chip or be included in a semiconductor chip. A semiconductor body has electrically connectable pads and includes at least one semiconductor element with electrodes.

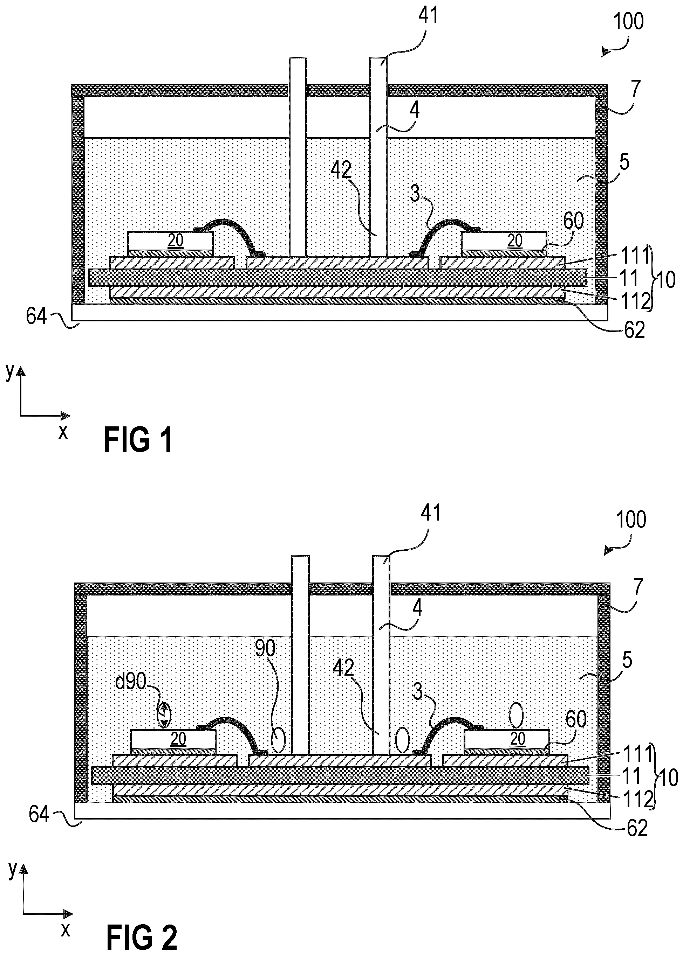

Referring to Figure 1, a cross-sectional view of a power semiconductor module arrangement 100 is illustrated. The power semiconductor module arrangement 100 includes a housing 7 and a substrate 10. The substrate 10 includes a dielectric insulation layer 11, a (structured) first metallization layer 111 attached to the dielectric insulation layer 11, and a (structured) second metallization layer 112 attached to the dielectric insulation layer 11. The dielectric insulation layer 11 is disposed between the first and second metallization layers 111, 112.

Each of the first and second metallization layers 111, 112 may consist of or include one of the following materials: copper; a copper alloy; aluminum; an aluminum alloy; any other metal or alloy that remains solid during the operation of the power semiconductor module arrangement. The substrate 10 may be a ceramic substrate, that is, a substrate in which the dielectric insulation layer 11 is a ceramic, e.g., a thin ceramic layer. The ceramic may consist of or include one of the following materials: aluminum oxide; aluminum nitride; zirconium oxide; silicon nitride; boron nitride; or any other dielectric ceramic. Alternatively, the dielectric insulation layer 11 may consist of an organic compound and include one or more of the following materials: Al₂O₃, AIN, SiC, BeO, BN, or Si₃N₄. For instance, the substrate 10 may, e.g., be a Direct Copper Bonding (DCB) substrate, a Direct Aluminum Bonding (DAB) substrate, or an Active Metal Brazing (AMB) substrate. Further, the substrate 10 may be an Insulated Metal Substrate (IMS). An Insulated Metal Substrate generally comprises a dielectric insulation layer 11 comprising (filled) materials such as epoxy resin or polyimide, for example. The material of the dielectric insulation layer 11 may be filled with ceramic particles, for example. Such particles may comprise, e.g., SiO₂, Al₂O₃, AlN, SiN or BN and may have a diameter of between about 1µm and about 50µm. The substrate 10 may also be a conventional printed circuit board (PCB) having a non-ceramic dielectric insulation layer 11. For instance, a non-ceramic dielectric insulation layer 11 may consist of or include a cured resin.

The substrate 10 is arranged in a housing 7. In the example illustrated in Figure 1, the substrate 10 is arranged on a base plate 64 which forms a base surface of the housing 7, while the housing 7 itself solely comprises sidewalls and a top or cover. In some power semiconductor module arrangements 100, more than one substrate 10 is arranged on the same base plate 64 and within the same housing 7. The base plate 64 may comprise a layer of a metallic material such as, e.g., copper or AlSiC. Other materials, however, are also possible. The base plate 64, however, can also be omitted. For example, the substrate 10 itself may form a base surface of the housing 7.

One or more semiconductor bodies 20 may be arranged on the at least one substrate 10. Each of the semiconductor bodies 20 arranged on the at least one substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), or any other suitable semiconductor element.

The one or more semiconductor bodies 20 may form a semiconductor arrangement on the substrate 10. In Figure 1, only two semiconductor bodies 20 are exemplarily illustrated. The second metallization layer 112 of the substrate 10 in Figure 1 is a continuous layer. According to another example, the second metallization layer 112 may be a structured layer. According to other examples, the second metallization layer 112 may be omitted altogether. The first metallization layer 111 is a structured layer in the example illustrated in Figure 1. "Structured layer" in this context means that the respective metallization layer is not a continuous layer, but includes recesses between different sections of the layer. Such recesses are schematically illustrated in Figure 1. The first metallization layer 111 in this example includes three different sections. Different semiconductor bodies 20 may be mounted to the same or to different sections of the first metallization layer 111. Different sections of the first metallization layer 111 may have no electrical connection or may be electrically connected to one or more other sections using electrical connections 3 such as, e.g., bonding wires. Semiconductor bodies 20 may be electrically connected to each other or to the first metallization layer 111 using electrical connections 3, for example. Electrical connections 3, instead of bonding wires, may also include bonding ribbons, connection plates or conductor rails, for example, to name just a few examples. The one or more semiconductor bodies 20 may be electrically and mechanically connected to the substrate 10 by an electrically conductive connection layer 60. Such an electrically conductive connection layer 60 may be a solder layer, a layer of an electrically conductive adhesive, or a layer of a sintered metal powder, e.g., a sintered silver (Ag) powder, for example. The one or more substrates 10 may be mechanically and thermally connected to a base plate 64 by means of a connection layer 62. The connection layer 62 may be an electrically insulating adhesive layer, a solder layer, a layer of an electrically conductive adhesive, or a layer of a sintered metal powder, e.g., a sintered silver (Ag) powder, for example.

The power semiconductor module arrangement 100 illustrated in Figure 1 further includes terminal elements 4. The terminal elements 4 provide an electrical connection between the inside and the outside of the housing 7. The terminal elements 4 may be electrically connected to the first metallization layer 111 with a second end 42, while a first end 41 of the terminal elements 4 protrudes out of the housing 7. The terminal elements 4 may be electrically contacted from the outside at their first end 41.

Arranging the terminal elements 4 centrally on the substrate 10 is only an example. According to other examples, terminal elements 4 may be arranged closer to or adjacent to the sidewalls of the housing 7. The second end 42 of a terminal element 4 may be electrically and mechanically connected to the substrate 10 by means of an electrically conductive connection layer (not specifically illustrated in Figure 1). Such an electrically conductive connection layer may be a solder layer, a layer of an electrically conductive adhesive, or a layer of a sintered metal powder, e.g., a sintered silver (Ag) powder, for example. Alternatively, the terminal elements 4 may also be coupled to the substrate by means of ultrasonic welding.

The power semiconductor module arrangement 100 further includes an encapsulant 5. The encapsulant 5 may consist of or include a cured silicone gel or may be a rigid molding compound, for example. The encapsulant 5 may at least partly fill the interior of the housing 7, thereby covering the components and electrical connections that are arranged on the substrate 10. The terminal elements 4 may be partly embedded in the encapsulant 5. At least their first ends 41, however, are not covered by the encapsulant 5 and protrude from the encapsulant 5 through the housing 7 to the outside of the housing 7. The encapsulant 5 is configured to protect the components and electrical connections of the power semiconductor module 100, in particular the components arranged inside the housing 7, from certain environmental conditions and mechanical damage.

The encapsulant 5 may comprise a single layer, as is schematically illustrated in Figure 1. This single layer may consist of a certain material. For example, the single layer of encapsulant 5 may be a cured silicone layer. According to some examples, the encapsulant 5 may comprise a comparably soft layer which has a sufficient adhesion to all surrounding elements and does not damage other module parts, for example, bond wires during thermal cycling expansion and contraction. A soft layer, however, may not be sufficiently mechanically stable due to reduced tear strength, and may show defects like bubble formation after thermal stress. A harder layer may provide a better robustness against defects after thermal stress, but does not adhere sufficiently, and may damage other module parts due to severe mechanical stress upon thermal cycling conditions. Similarly, different materials that are generally suitable for forming a layer of encapsulant 5 may provide only specific properties, while their other properties may not be satisfying.

Now referring to Figure 2, a semiconductor module arrangement 100 according to embodiments of the disclosure is schematically illustrated. The semiconductor module arrangement 100 as illustrated in Figure 2 essentially corresponds to the semiconductor module arrangement 100 as has been described with respect to Figure 1 above. The encapsulant 5 in this example comprises a single layer consisting of a certain material. However, in the semiconductor module arrangement illustrated in Figure 2, a structure 90 is embedded in the encapsulant 5 (i.e. in the single layer of the encapsulant 5). The structure 90 comprises or consists of a material that it different from the material of the layer of the encapsulant 5 it is embedded in.

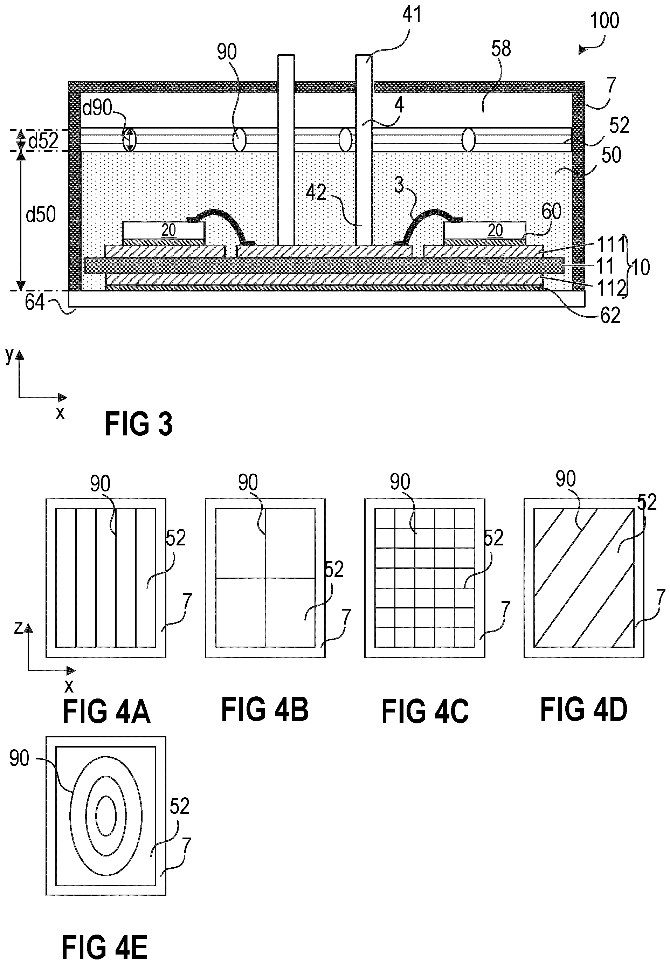

That is, a semiconductor module arrangement according to embodiments of the disclosure comprises a housing 7 comprising sidewalls, a substrate 10 with at least one semiconductor body 20 arranged thereon, wherein the substrate 10 is arranged in or forms a base surface of the housing 7, an encapsulant 5, partly filling the housing 7, and completely covering the substrate 10 and the at least one semiconductor body 20 arranged thereon, wherein the encapsulant 5 comprises one or more layers, and a structure 90, wherein the structure 90 is embedded in one layer of the one or more layers of the encapsulant 5, and wherein the structure 90 comprises or consists of a material that it different from the material of the layer it is embedded in. The material of the structure 90 provides different properties as compared to the material of the layer the encapsulant 5 it is embedded in. For example, if the respective layer of encapsulant 5 is a comparably soft layer, the structure 90 may be hard as compared to the layer. In this way, the mechanical strength of the layer of encapsulant 5 may be improved while, at the same time, e.g., a sufficient adhesion and reduced mechanical stress in the interface to other module parts of the layer remain essentially unchanged. Similarly, it would also be possible to embed a comparably soft structure 90 in a comparably hard layer of encapsulant 5. A hard layer of encapsulant 5 which is in direct contact with the substrate 10 and components arranged on the substrate 10 may exert a high mechanical stress on the substrate 10 and on the components arranged thereon. A soft structure 90 embedded in a comparably hard layer of encapsulant 5 may reduce the mechanical stress exerted by the respective layer. A structure 90 embedded in a layer of encapsulant 5, however, may additionally or alternatively also positively affect any other properties of the respective layer, e.g., electrical conductivity, thermal conductivity, etc. The structure 90 may be embedded in a lower part of the encapsulant 5, close to the substrate 10 and the components arranged thereon, similar to what is illustrated in Figure 2. This, however, is only an example. A structure 90 may generally be embedded anywhere within the respective layer, at any position where certain improved properties may be required. For example, the structure 90 could also be arranged adjacent to a top surface of the encapsulant 5, the top surface of the encapsulant 5 facing away from the substrate 10, similar to what will be described with respect to Figure 3 below.

Now referring to Figure 3, another power semiconductor module arrangement 100 according to embodiments of the disclosure is schematically illustrated. The power semiconductor module arrangement 100 generally corresponds to the power semiconductor module arrangement 100 that has been described with respect to Figure 1 above. In the example illustrated in Figure 3, however, the encapsulant 5 comprises two layers, namely a first layer 50 and a second layer 52. The first layer 50 partly fills the housing 7 and completely covers the substrate 10 and the at least one semiconductor body 20 arranged thereon. The second layer 52 is arranged adjacent to the first layer 50 such that the first layer 50 is arranged between the second layer 52 and the substrate 10. The second layer 52 may be arranged distant from the top of the housing 7, for example. That is, an area arranged between the first layer 50 and the top of the housing 7 may only be partly filled with the material of the second layer 52, and a cavity 58 may remain between the second layer 52 and the top of the housing 7. This cavity 58 may be filled with air, for example.

The first layer 50 and the second layer 52 may consist of different materials, thereby providing different properties. For example, the first layer 50 may be a thermostable layer that is able to withstand the high temperatures arising in the power semiconductor module arrangement. If the first layer 50 is a thermostable layer, it does not become brittle during the lifetime of the power semiconductor module arrangement. A thermostable first layer 50, however, may not be able to sufficiently protect the substrate 10 and the elements mounted thereon (e.g., the semiconductor bodies 20 and electrical connections 3) from environmental conditions and mechanical damage. This may be achieved by arranging the second layer 52 on top of the first layer 52. The second layer 52, e.g., may be a mechanically stable layer which, however, usually is not thermostable. One or more properties of the second layer 52 may be enhanced by embedding the structure 90 therein.

Gas bubbles may form in almost every potting material during the operation of the power semiconductor module arrangement. According to one embodiment, the first layer 50 may be a liquid layer. In this way, local hot spots in the first layer 50 in vicinity of the substrate 10 can be avoided or at least significantly reduced. When a semiconductor body 20 heats during the use of the power semiconductor module arrangement 100, the material of a liquid first layer 50 also heats to a certain degree in those areas directly adjoining the semiconductor body 20. A liquid layer, however, allows convection. That is, as the material of the first layer 50 gets heated in the areas close to the semiconductor bodies 20, it rises and carries away the heat from the semiconductor body 20 towards the second layer 52. As the material rises, it cools down again, sinking down again towards the substrate 10. Any heat that is transferred from a semiconductor body 20 to the first layer 50, therefore, is not aggregated in the areas close to the semiconductor bodies 20 such that no, or only insignificant local hot spots occur. The heat is rather distributed to other areas of the first layer 50. Further, any gas bubbles as well as delaminated material will not accumulate in the areas close to the semiconductor bodies 20, but will rather be distributed over the entire liquid first layer 50.

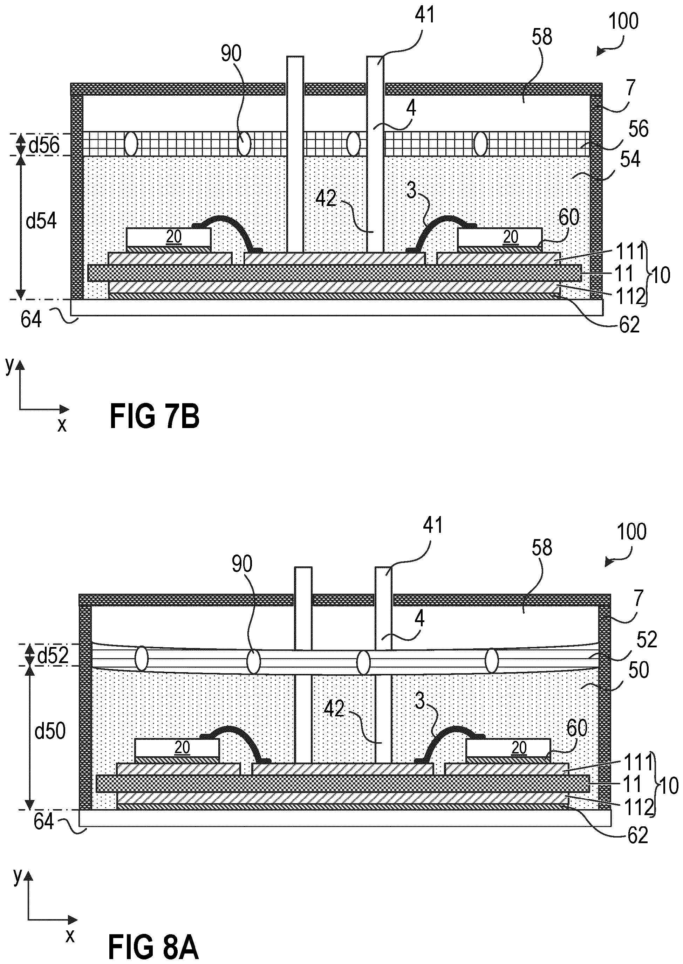

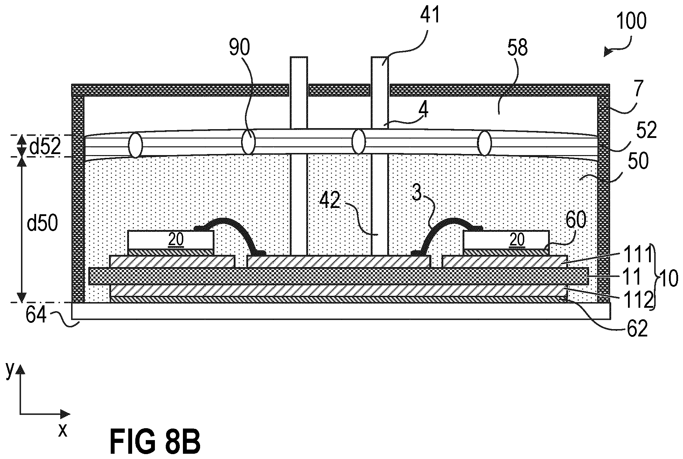

However, a liquid, when heated, expands to a certain degree and contracts when it cools down again. This may be problematic in sealed housings, as pressure builds up inside the housing when the liquid layer expands. For this reason, a solid second layer 52 may be arranged above a liquid first layer 50. The second layer 52 may be a cured (silicone) layer, for example. The second layer 52, may be flexible to a certain degree. That is, the second layer 52 may be configured to deform when the first layer 50 expands or contracts (schematically illustrated in Figures 8A, contraction, and 8B, expansion). The second layer 52 prevents the liquid material of the first layer 50 from flowing out of the housing 7. That is, the second layer 52 seals the lower part of the housing 7 in which the first layer 50 is arranged. The housing 7 may comprise an opening (not specifically illustrated) that is arranged to allow air to flow in or out of the cavity 58 from or to the outside of the housing 7. That is, as the first layer 50 expands, the second layer 52 may deform towards the top of the housing 7 (see, e.g., Figure 8B). The volume of the cavity 58, therefore, may decrease. In order to prevent pressure from building up inside the housing 7, air may be able to escape from the housing 7 through the opening. The second layer 52 may have certain adhesive properties and may adhere to the sidewalls of the housing 7. In this way, it remains in place during the use of the power semiconductor module arrangement 100.

The encapsulant 5 in the arrangement as illustrated in Figure 3 is a multilayer encapsulant comprising at least two layers, wherein each layer serves a different purpose as has been described by means of different examples above. A thermostable first layer 50 and a mechanically stable second layer 52, or a liquid first layer 50 and a solid second layer 52 are only examples. The different layers may have any specific properties that may be required for a specific power semiconductor module arrangement. Generally, an encapsulant 5 of a power semiconductor module 100 may comprise even more than two layers.

The power semiconductor module arrangement 100 illustrated in Figure 3 further comprises a structure 90 embedded in the second layer 52, the structure 90 comprising or consisting of a third material that it different from the material of the second layer 52. The structure 90 and the material of the second layer 52 may collaborate, thereby providing enhanced properties over each of the second layer 52 and the structure 90 alone. For example the material used to form the second layer 52 may be flexible to be able to deform when a liquid first layer 50 expands or contracts. It may, however, not be strong enough and may rupture or get otherwise damaged over the lifetime of the power semiconductor module arrangement 100 due to the expansion/contraction of the first layer 50. The structure 90 may comprise or consist of a material that is more rigid than the material of the second layer 52, for example. In this way, a certain stability may be provided by the structure 90, while the second layer 52 remains flexible enough to allow the required deformation.

Embedding a structure 90 in a topmost layer of an encapsulant 5 comprising two or more layers, however, is only an example. In the example illustrated in Figure 3, the structure 90 could also be embedded in the first layer 50 instead. In an encapsulant 5 comprising even more than two layers (not specifically illustrated), a structure 90 may be embedded in any of the more than two layers in order to enhance certain properties of the respective layer. It is generally also possible that a first structure 90 is embedded in a first layer of a plurality of layers, and a second structure 90 is embedded in a second layer of the plurality of layers, each of the first and second structure 90 enhancing certain properties of the respective layer it is embedded in. It is even possible that a first structure 90 comprising certain material properties and a second structure 90 comprising different material properties are embedded in one and the same layer of an encapsulant 5.

Generally speaking, the material of a layer of an encapsulant 5 may have a plurality of material properties, and the material of a structure 90 embedded in the respective layer may have a plurality of material properties, and at least one of the material properties of the material of the respective layer may differ from a respective one of the material properties of the material of the structure 90 embedded therein. The at least one of the material properties of the material of the respective layer which differs from a respective one of the material properties of the material of the structure 90 may comprise at least one of a coefficient of thermal expansion, a modulus of elasticity, a tensile strength, electrical insulation capability, locally defined electrical conductivity and thermal conductivity. That is, for example, the material of the respective layer may have a coefficient of thermal expansion which differs from a coefficient of thermal expansion of the material of the structure 90. In this way, by embedding the structure 90 in the respective layer, the resulting overall coefficient of thermal expansion may be higher or lower than the coefficient of thermal expansion of the material of the respective layer alone. Whether the overall resulting coefficient of thermal expansion is higher or lower than the coefficient of thermal expansion of the material of the respective layer depends on the coefficient of thermal expansion of the material of the structure 90. Any other material properties of the material of the respective layer may be adjusted or counterbalanced by means of a structure 90 in a similar way. That is, for example, a structure 90 may provide stability to the respective second layer, it may increase the electrical insulation capability, locally defined electrical conductivity, thermal conductivity or it may reduce a mechanical stress exerted by the respective layer.

The structure 90 may form a defined pattern or shape in the respective layer. That is, the structure 90 may not only be randomly arranged in the respective layer, as would be the case, for example, for filler particles randomly distributed within the material of the respective layer. Examples of defined patterns or shapes are schematically illustrated by means of Figure 4. The structure 90 may generally form any suitable defined pattern or shape, wherein the pattern or shape may depend on which properties of the respective layer are to be adjusted or counterbalanced by means of the structure 90. For example, the defined pattern may comprise at least one of a single elongated strand (not specifically illustrated), a plurality of parallel strands (e.g., Figures 4A and 4D), two strands forming a cross (e.g., Figure 4B), a plurality of strands forming a grid (e.g., Figure 4C), or one or more strands, wherein each of the one or more strands forms a continuous loop (e.g., Figure 4E). In the example illustrated in Figure 4A, for example, the structure 90 comprises a plurality of separate strands extending in parallel to each other from one sidewall of the housing 7 to an opposite sidewall of the housing 7. In the example illustrated in Figure 4B, a cross is formed by two separate strands, wherein each of the two separate strands extends from a different one of the sidewalls to a respective opposite sidewall. According to another example, two strands could also extend between two respective opposite corners, thereby forming a cross. In the example illustrated in Figure 4C, a plurality of strands form a grid in the respective layer. In the example illustrated in Figure 4D, a plurality of separate strands extend in parallel diagonally through the housing 7, from one sidewall of the housing 7 to another sidewall of the housing 7. In the example illustrated in Figure 4E, the structure 90 comprises a plurality of strands, wherein each of the one or more strands forms a continuous loop. The loops in the example of Figure 4E have oval shapes. Any other shapes, however, such as, e.g., rectangular, circular, square or any other regular or irregular shapes are also possible.

The patterns illustrated in Figures 4A to 4D, for example, may provide stability to the respective layer. Alternatively or additionally, other properties of the respective layer may be adjusted or counterbalanced by such patterns. A single strand of a different material (not specifically illustrated) embedded in a respective layer may be sufficient in some cases. For example, a single strand of soft material embedded in a comparably hard layer of encapsulant 5 may act as an expansion joint, and significantly reduce the mechanical stress exerted on the substrate 10 and/or any components arranged therein by the hard layer. It is also possible that the structure 90 forms a sponge, wherein the pores of the sponge are filled with the material of the respective layer. Any other suitable patterns or shapes are generally possible.

A thickness d90 of the structure 90 may equal a thickness d52 of the respective layer 52 it is embedded in, similar to what is exemplarily illustrated in Figure 3. The thickness d90 of the structure 90, however, may also be smaller than the thickness of the respective layer, for example, similar to what is exemplarily illustrated in Figure 2. It is even possible that the thickness d90 of the structure 90 is somewhat larger than the thickness of the respective layer due to reasons relating to the method that is used to form the structure 90 and the respective layer. Different strands of a structure 90 may be arranged in one and the same plane, similar to what is illustrated in Figure 3. It is, however, also possible that different strands of one and the same structure 90 are arranged in different planes, similar to what is illustrated in Figure 2, for example.

The material of the structure 90 may comprise or consist of a silicone, an epoxy, a polyurethane, or a polyamide, for example. Other materials, however, are generally also possible. The material of the structure 90 may be an electrically insulating material, for example, in order to provide electrical insulation towards the outside of the housing 7. According to some embodiments of the disclosure, the structure 90 may comprise an electrically conducting material (e.g., a metal) coated by an electrically insulating material. That is, thin wires may be formed inside the structure 90. Such wires could be used to electrically contact the substrate 10 or any elements mounted thereon from the outside of the housing 7, for example.

The power semiconductor module arrangements 100 according to the embodiments that have been exemplarily described above can be produced in different ways. Different methods for forming a power semiconductor module arrangement 100 will exemplarily described in the following. Generally, a method for forming a power semiconductor module arrangement 100 comprises forming an encapsulant 5 in a housing 7 of a power semiconductor module arrangement 100, the housing 7 comprising sidewalls, and the power semiconductor module arrangement 100 comprising substrate 10 with at least one semiconductor body 20 arranged thereon, wherein the substrate 10 is arranged in or forms a base surface of the housing 7. The encapsulant 5 comprises one or more layers 50, 52. A structure 90 is embedded in one layer of the one or more layers 50, 52 of the encapsulant 5, wherein the structure 90 comprises or consists of a material that it different from the material of the layer it is embedded in. The one or more layers 50, 52 of the encapsulant 5 as well as the structure 90 may be formed in different ways.

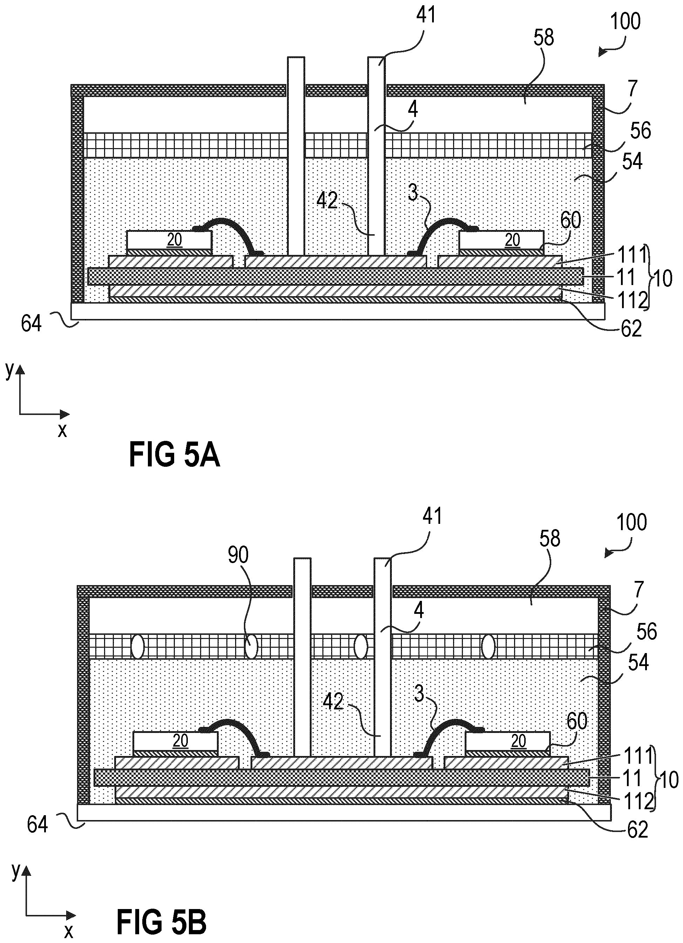

Now referring to Figure 5, one exemplary method for forming a power semiconductor module arrangement 100 according to embodiments of the disclosure will be described. A method for forming a power semiconductor module arrangement according to embodiments of the disclosure may comprise filling a first material having a first density ρ1 in a housing 7, thereby forming a liquid or gel-like first pre-layer 54. The housing 7 comprises sidewalls and (optionally) a top, and a substrate 10 with at least one semiconductor body 20 arranged thereon is arranged in or forms a base surface of the housing 7. The first pre-layer 54 partly fills the housing 7 and completely covers the substrate 10 and the at least one semiconductor body 20 arranged thereon. The method further comprises filling a second material being different from the first material and having a second density p2 in the housing 7, wherein the first density ρ1 is higher than the second density ρ2, thereby forming a liquid or gel-like second pre-layer 56 consisting of the second material. The first pre-layer 54, due to its higher density ρ1, forms between the second pre-layer 56 and the substrate 10. This is schematically illustrated in Figure 5A.

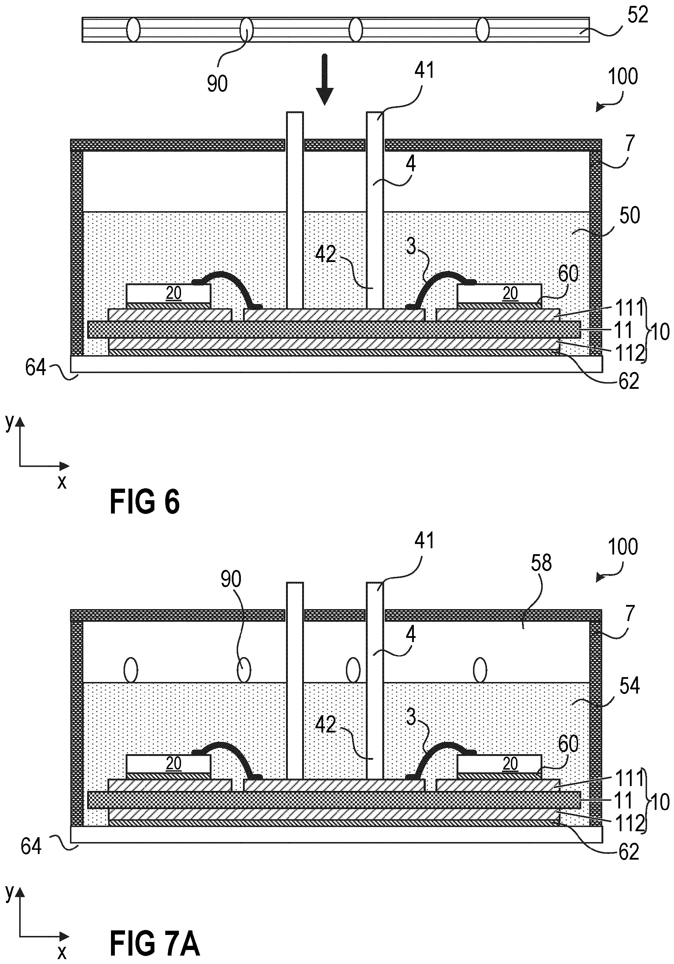

The structure 90 may be formed in the second pre-layer 56 in different ways. According to one example, a pre-fabricated solid structure 90 is arranged on the first layer 50 either before or after filling the second material in the housing 7. It is, however, also possible to form the structure 90 in the housing 7 by dispensing a liquid or gel-like third material on the first layer 50 either before or after filling the second material in the housing 7. A structure 90 formed or arranged in the housing 7 after forming the second pre-layer 56 is schematically illustrated in Figure 5B. An exemplary method in which the structure 90 is formed or arranged in the housing 7 after forming the first pre-layer 54 and before forming the second pre-layer 56 is schematically illustrated by means of Figures 7A and 7B.

A third density of the material of the structure 90 may be lower than the first density of the first material such that the structure 90 does not sink into the liquid or viscous first pre-layer 54. Irrespective of the order in which the layers and the structure 90 are formed, a curing step may be performed during which the first pre-layer 54 and the second pre-layer 56 are cured. If the structure 90 is formed by dispensing a liquid or gel-like third material, the liquid or gel-like third material may also be cured during the (single) curing step.

It is, however, also possible that the first material is first filled into the housing 7 to form a first pre-layer 54. This first pre-layer 54 may then be cured to form the first layer 50. The second material may then be filled into the housing 7 on top of the cured first layer 50 to form a second pre-layer 56 and a second curing step may be performed. The structure 90 may be arranged or formed on the cured first layer 50 at any point before curing the second pre-layer 56. That is, the structure 90 may be arranged or formed on the first layer 50 either before or after filling the second material in the housing 7. Similar to what has been described above, the structure 90 may be a pre-fabricated solid structure that is inserted into the housing 7 and arranged on the first layer 50, or the structure 90 may be formed in the housing 7 by dispensing a liquid or gel-like third material on the first layer 50. In the latter case, the third material may be cured at the same time as the second material.

According to an even further example, and as is schematically illustrated in Figure 6, forming the first layer 50 may comprise filling a liquid or gel-like first material in the housing 7 and curing the liquid or gel-like first material, and forming the second layer 52 with the structure 90 embedded therein may comprise forming a mat comprising the second material and the structure 90 embedded therein, and inserting the prefabricated mat in the housing 7. The mat may be formed in a suitable mold, for example, outside of the housing 7.

If, for example, the encapsulant 5 comprises only a single layer (see, e.g., Figure 2), or if the structure 90 is embedded in a layer of a plurality of layers which is arranged closest to the substrate 10, forming the encapsulant 5 may comprise forming a first layer 50 with the structure 90 embedded therein by forming the structure 90 on the substrate 10, and filling a liquid or gel-like first material in the housing 7, and curing the first material. Similar to what has been described above, the structure 90 may be a pre-fabricated solid structure that is inserted into the housing 7 and arranged on the substrate 10, or the structure 90 may be formed in the housing 7 by dispensing a liquid or gel-like material on the substrate 10. In the latter case, the material of the structure 90 may be cured at the same time as the material of the respective first layer 50.

In another example, the material of the embedded structure 90 may comprise or consist of a thixotropic material, e.g., a thixotropic silicone gel. A thixotropic material may be solid, thick, or viscous under certain conditions (e.g., static conditions), and will flow (become thinner, or less viscous) over time when, e.g., shear-stressed, or otherwise stressed (time-dependent viscosity). Once the stress decreases, the thixotropic material returns to its state under static conditions. The longer a thixotropic material (e.g., silicone gel) undergoes shear-stress, for example, the lower its viscosity. In this way, the structure 90 can be formed and will not move upon the addition of a liquid layer. The structure 90 and the respective layer can be cured at the same time. It is also possible to build the structure 90 with a curable material, e.g., silicone gel or epoxy or other suitable materials, and cure it in a separate thermal step. The hollow body defined by the housing 7 with a cured structure 90 arranged inside can then be filled with the encapsulant 5 and is subsequently cured in a follow-up thermal step.

## Claims

1. A power semiconductor module arrangement (100) comprising:
a housing (7) comprising sidewalls,
a substrate (10) with at least one semiconductor body (20) arranged thereon, wherein the substrate (10) is arranged in or forms a base surface of the housing (7),
an encapsulant (5) partly filling the housing (7), and completely covering the substrate (10) and the at least one semiconductor body (20) arranged thereon, wherein the encapsulant (5) comprises one or more layers (50, 52), and
a structure (90), wherein the structure (90) is embedded in one layer of the one or more layers (50, 52) of the encapsulant (5), and wherein the structure (90) comprises or consists of a material that it different from the material of the layer it is embedded in.

2. The power semiconductor module arrangement (100) of claim 1, wherein the material of the layer the structure (90) is embedded in has a plurality of material properties, and the material of the structure (90) has a plurality of material properties, and wherein at least one of the material properties of the material of the layer differs from a respective one of the material properties of the material of the structure (90).

3. The power semiconductor module arrangement (100) of claim 2, wherein the at least one of the material properties of the material of the layer the structure (90) is embedded in and which differs from a respective one of the material properties of the material of the structure (90) comprises at least one of a coefficient of thermal expansion, a modulus of elasticity, a tensile strength, thermal conductivity, an electrical insulation capability, and electrical conductivity

4. The power semiconductor module arrangement (100) of any of claims 1 to 3, wherein the structure (90) forms a defined pattern in the respective layer (50, 52).

5. The power semiconductor module arrangement (100) of claim 4, wherein the pattern comprises at least one of
a single elongated strand,
a plurality of parallel strands,
two strands forming a cross,
a plurality of strands forming a grid, or
one or more strands, wherein each of the one or more strands forms a continuous loop.

6. The power semiconductor module arrangement (100) of claim 4 or 5, wherein the pattern comprises one or more strands, wherein each of the one or more strands extends from one sidewall of the housing (7) to another sidewall of the housing (7).

7. The power semiconductor module arrangement (100) of any of the preceding claims, wherein the material of the structure (90) comprises or consists of a thixotropic material.

8. The power semiconductor module arrangement (100) of any of the preceding claims, wherein the material of the structure (90) comprises or consists of a silicone, an epoxy, a polyurethane, or a polyamide.

9. A method comprising
forming an encapsulant (5) in a housing (7) of a power semiconductor module arrangement (100), the housing (7) comprising sidewalls, and the power semiconductor module arrangement (100) comprising a substrate (10) with at least one semiconductor body (20) arranged thereon, wherein the substrate (10) is arranged in or forms a base surface of the housing (7), wherein
the encapsulant (5) comprises one or more layers (50, 52), and
a structure (90) is embedded in one layer of the one or more layers (50, 52) of the
encapsulant (5), wherein the structure (90) comprises or consists of a material that it different from the material of the layer it is embedded in.

10. The method of claim 9, wherein forming the encapsulant (5) comprises:
forming a first layer (50) by filling a liquid or gel-like first material in the housing (7) and curing the liquid or gel-like first material, and
forming a second layer (52) with the structure (90) embedded therein by forming a mat with the structure (90) embedded therein, and inserting the prefabricated mat in the housing (7).

11. The method of claim 9, wherein forming the encapsulant (5) comprises:
forming a first layer (50) by filling a liquid or gel-like first material in the housing (7) and curing the liquid or gel-like first material, and
forming a second layer (52) with the structure (90) embedded therein, wherein forming the second layer (52) comprises forming or arranging the structure (90) on the cured first layer (50), filling a liquid or gel-like second material in the housing (7), and curing the liquid or gel-like second material.

12. The method of claim 11, wherein forming or arranging the structure (90) on the first layer (50) comprises
arranging a pre-fabricated solid structure (90) on the first layer (50), or
dispensing a liquid or gel-like third material on the first layer (50), and curing the liquid or gel-like third material.

13. The method of claim 9, wherein forming the encapsulant (5) comprises (7),
forming a first layer (50) by filling a liquid or gel-like first material in the housing
forming a second layer (52) with the structure (90) embedded therein by forming the structure (90) on the liquid or gel-like first material, and filling a liquid or gel-like second material in the housing (7), wherein
the first material comprises a first density, the second material comprises a second density, and the structure (90) comprises a third density, wherein the first density is higher than the second density and the third density, and
the method further comprises curing at least the liquid or gel-like second material.

14. The method of claim 9, wherein forming the encapsulant (5) comprises:
forming a first layer (50) with the structure (90) embedded therein by forming the structure (90) on the substrate (10), and filling a liquid or gel-like first material in the housing (7), and
curing the first material.

## Amended claims

### Amended claims in accordance with Rule 137(2) EPC.

1. A power semiconductor module arrangement (100) comprising:
a housing (7) comprising sidewalls,
a substrate (10) with at least one semiconductor body (20) arranged thereon, wherein the substrate (10) is arranged in or forms a base surface of the housing (7),
an encapsulant (5) partly filling the housing (7), and completely covering the substrate (10) and the at least one semiconductor body (20) arranged thereon, wherein the encapsulant (5) comprises one or more layers (50, 52), and
a structure (90), wherein
the structure (90) is embedded in one layer of the one or more layers (50, 52) of the encapsulant (5), and wherein the structure (90) comprises or consists of a material that is different from the material of the layer it is embedded in.
the structure (90) forms a defined pattern in the respective layer (50, 52),
the pattern comprises at least one of
a single elongated strand,
a plurality of parallel strands,
two strands forming a cross,
a plurality of strands forming a grid, or
one or more strands, wherein each of the one or more strands forms a continuous loop, and
the different strands of the structure (90) are arranged in one and the same plane.

2. The power semiconductor module arrangement (100) of claim 1, wherein the material of the layer the structure (90) is embedded in has a plurality of material properties, and the material of the structure (90) has a plurality of material properties, and wherein at least one of the material properties of the material of the layer differs from a respective one of the material properties of the material of the structure (90).

3. The power semiconductor module arrangement (100) of claim 2, wherein the at least one of the material properties of the material of the layer the structure (90) is embedded in and which differs from a respective one of the material properties of the material of the structure (90) comprises at least one of a coefficient of thermal expansion, a modulus of elasticity, a tensile strength, thermal conductivity, an electrical insulation capability, and electrical conductivity

4. The power semiconductor module arrangement (100) of any of claims 1 to 3, wherein the pattern comprises one or more strands, wherein each of the one or more strands extends from one sidewall of the housing (7) to another sidewall of the housing (7).

5. The power semiconductor module arrangement (100) of any of the preceding claims, wherein the material of the structure (90) comprises or consists of a thixotropic material.

6. The power semiconductor module arrangement (100) of any of the preceding claims, wherein the material of the structure (90) comprises or consists of a silicone, an epoxy, a polyurethane, or a polyamide.

7. A method comprising
forming an encapsulant (5) in a housing (7) of a power semiconductor module arrangement (100), the housing (7) comprising sidewalls, and the power semiconductor module arrangement (100) comprising a substrate (10) with at least one semiconductor body (20) arranged thereon, wherein the substrate (10) is arranged in or forms a base surface of the housing (7), wherein
the encapsulant (5) comprises one or more layers (50, 52), and
a structure (90) is embedded in one layer of the one or more layers (50, 52) of the encapsulant (5), wherein the structure (90) comprises or consists of a material that is different from the material of the layer it is embedded in, wherein
the structure (90) forms a defined pattern in the respective layer (50, 52),
the pattern comprises at least one of
a single elongated strand,
a plurality of parallel strands,
two strands forming a cross,
a plurality of strands forming a grid, or
one or more strands, wherein each of the one or more strands forms a continuous loop, and
the different strands of the structure (90) are arranged in one and the same plane.

8. The method of claim 7, wherein forming the encapsulant (5) comprises:
forming a first layer (50) by filling a liquid or gel-like first material in the housing (7) and curing the liquid or gel-like first material, and
forming a second layer (52) with the structure (90) embedded therein by forming a mat with the structure (90) embedded therein, and inserting the prefabricated mat in the housing (7), wherein
when the prefabricated mat has been inserted into the housing (7), the first layer (50) is arranged between the second layer (52) and the substrate (10).

9. The method of claim 8, wherein forming the encapsulant (5) comprises:
forming a first layer (50) by filling a liquid or gel-like first material in the housing (7) and curing the liquid or gel-like first material, and
forming a second layer (52) with the structure (90) embedded therein, wherein forming the second layer (52) comprises forming or arranging the structure (90) on the cured first layer (50), filling a liquid or gel-like second material in the housing (7), and curing the liquid or gel-like second material.

10. The method of claim 9, wherein forming or arranging the structure (90) on the first layer (50) comprises
arranging a pre-fabricated solid structure (90) on the first layer (50), or
dispensing a liquid or gel-like third material on the first layer (50), and curing the liquid or gel-like third material.

11. The method of claim 7, wherein forming the encapsulant (5) comprises
forming a first layer (50) by filling a liquid or gel-like first material in the housing (7),
forming a second layer (52) with the structure (90) embedded therein by forming the structure (90) on the liquid or gel-like first material, and filling a liquid or gel-like second material in the housing (7), wherein
the first material comprises a first density, the second material comprises a second density, and the structure (90) comprises a third density, wherein the first density is higher than the second density and the third density, and
the method further comprises curing at least the liquid or gel-like second material.

12. The method of claim 7, wherein forming the encapsulant (5) comprises:
forming a first layer (50) with the structure (90) embedded therein by forming the structure (90) on the substrate (10), and filling a liquid or gel-like first material in the housing (7), and
curing the first material.
